# EUROPÄISCHE PATENTANMELDUNG

(11) **EP 3 018 485 A1**
(43) Veröffentlichungstag der Anmeldung: **11.05.2016**
(21) Anmeldenummer: 14197617.5
(22) Anmeldetag: 12.12.2014
(51) Int. Cl.: G01R 31/327

(54) **Schutzschaltvorrichtung und Verfahren zum Strommessen**

(30) Priorität: 06.11.2014 EP 14192069
(71) Anmelder: Siemens Aktiengesellschaft, 80333 München (DE)
(72) Erfinder: Dhanraj, Vinod Gideon, 93128 Regenstauf (DE); Festl, Florian, 93051 Regensburg (DE); Hueber, Alexander, 84085 Niederleierndorf (DE); Martel, Jean-Mary, 93105 Tegernheim (DE)

(57) **Zusammenfassung**

Die Überwachung von Schaltkreisen soll vereinfacht werden. Dazu wird eine Schutzschaltvorrichtung mit einem Gehäuse (13), einem Strompfad in dem Gehäuse, einer in das Gehäuse eingebauten Schalteinrichtung zum Unterbrechen des Strompfads und einer in das Gehäuse eingebauten Kommunikationseinrichtung (3) bereitgestellt. Die Schutzschaltvorrichtung besitzt ferner eine Sensoreinrichtung (1) zum Messen eines Stroms in dem Strompfad und/oder einer Spannung an dem Strompfad sowie zum Bereitstellen eines entsprechenden Messsignals, wobei die Kommunikationseinrichtung (3) zum Senden des Messsignals aus dem Gehäuse (13) ausgebildet ist.

## Beschreibung

Die vorliegende Erfindung betrifft eine Schutzschaltvorrichtung mit einem Gehäuse, einem Strompfad in dem Gehäuse, eine in das Gehäuse eingebauten Schalteinrichtung zum Unterbrechen des Strompfads und einer in das Gehäuse eingebauten Kommunikationseinrichtung. Darüber hinaus betrifft die vorliegende Erfindung ein Verfahren zum Messen eines Stroms in einem Strompfad und/oder einer Spannung in einem Strompfad.

Eine Schutzschaltvorrichtung wie z. B. ein Fehlerstromschutzschalter (englisch: "Residual Current protective Device" RCD), dient dazu, einen Stromkreis bei Auftreten eines Fehlerstroms zu unterbrechen. So sind beispielsweise in einem dreiadrigen System mit Phasenleiter, Nullleiter und Schutzleiter das dreiadrige Leitersystem getrennt, bzw. entsprechende Schalter geöffnet, wenn in dem Schutzleiter ein Fehlerstrom detektiert wird.

Schutzschaltvorrichtungen wie beispielsweise ein AFDD (Arc Fault Detection Device = Fehlerlichtbogen-Schutzeinrichtung oder Brandschutzschalter) oder ein digitaler RCD können mehrere Sensoren beinhalten. Damit lassen sich zahlreiche Messwerte wie beispielsweise über den Strom, die Spannung, die Frequenz, den Fehler, Auslöseereignisse und die Zeit gewinnen. Teilweise werden solche Daten in dem Gerät gespeichert. Insbesondere werden diese Daten benutzt, um die Schutzschaltvorrichtung auszulösen und den jeweiligen Strompfad zu unterbrechen.

Andererseits ist von der Firma Gewiss ein Kommunikationssystem "Smartlink" für Reiheneinbaugeräte bekannt. Dieses Kommunikationssystem verfügt über eine integrierte Internetschnittstelle und analoge Eingänge für z. B. Temperatur- und Feuchtigkeitsüberwachung. Über den integrierten Web-Server werden per Smartphone, Tablet oder PC die Schaltzustände der einzelnen Reiheneinbaugeräte (Ein, Aus, Ausgelöst) dargestellt. Mit entsprechenden Nutzerrechten besteht die Möglichkeit, Fernantriebe, Schütze oder Stromstoßrelais zu schalten.

Die Aufgabe der vorliegenden Erfindung besteht darin, die Überwachung in Installationssystemen zu vereinfachen.

Erfindungsgemäß wird diese Aufgabe gelöst durch eine Schutzschaltvorrichtung mit einem Gehäuse, einem Strompfad in dem Gehäuse, einer in das Gehäuse eingebauten Schalteinrichtung zum Unterbrechen des Strompfads und einer in das Gehäuse eingebauten Kommunikationseinrichtung, sowie mit einer Sensoreinrichtung zum Messen eines Stroms in dem Strompfad und/oder einer Spannung an dem Strompfad sowie zum Bereitstellen eines entsprechenden Messsignals, wobei die Kommunikationseinrichtung zum Senden des Messsignals aus dem Gehäuse ausgebildet ist.

Darüber hinaus wird erfindungsgemäß bereitgestellt ein Verfahren zum Messen eines Stroms in einem Stompfad und/oder einer Spannung an einem Strompfad durch Bereitstellen einer Schutzschaltvorrichtung, durch deren Gehäuse der Strompfad hindurch verläuft, Messen des Stroms in dem Strompfad und/oder der Spannung an dem Strompfad innerhalb des Gehäuses und Bereitstellen eines entsprechenden Messsignals, und Senden des Messsignals aus dem Gehäuse heraus.

In vorteilhafter Weise wird somit eine Schutzschaltvorrichtung bereitgestellt, deren Sensoreinrichtung zur Messung eines tatsächlichen Stromwerts oder einer tatsächlichen Spannung in der Lage ist. Dieser Stromwert oder Spannungswert wird dann in ein Messsignal integriert. Dazu kann der jeweilige Stromwert oder Spannungswert direkt oder vorarbeitet in das Messsignal eingehen. Die Kommunikationseinrichtung ist so in der Lage, das Messsignal und damit den Stromwert und/oder Spannungswert bzw. einen darauf basierenden Wert nach außen aus dem Gehäuse zu übertragen. Auf diese Weise lässt sich die Schutzschaltvorrichtung als Strom- und/oder Spannungsmesser verwenden. Die Schutzschaltvorrichtung erhält damit neben der orginären Schaltfunktionalität eine zusätzliche Informationsfunktionalität bezüglich des durch den Strompfad fließenden Stroms oder der an dem Strompfad anliegenden Spannung. Damit kann die Schutzschaltvorrichtung Informationen nach außen geben, die nicht unmittelbar mit der Schaltfunktonalität der Schalteinrichtung im Zusammenhang steht. Dies aber bedeutet, dass auf spezielle Strommesser und Spannungsmesser in Installationssystemen verzichtet werden kann, wenn entsprechende Schutzschaltvorrichtungen in das Installationssystem integriert sind.

Vorzugsweise ist die Kommunikationseinrichtung zum drahtlosen Senden des Messsignals ausgebildet. Damit ist es möglich, das Messsignal beispielsweise mittels WLAN, Bluetooth oder dergleichen drahtlos an Auswerteeinrichtungen (z. B. tragbarer Computer) zu übertragen.

In der Kommunikationseinrichtung kann ein Code hinterlegt sein, mit dem die Schutzschaltvorrichtung bei einem Senden des Messsignals oder bei einer anderen Datenkommunikation identifizierbar ist. Bei Betrieb mehrerer derartiger Schutzschaltvorrichtungen ist es dann möglich, jede einzelne dieser Schutzschaltvorrichtungen eindeutig identifizieren zu können. Beispielsweise kann nämlich der Code jeder Schutzschaltvorrichtung mit dem jeweils abgesandten Messsignal versandt werden.

Die Sensoreinrichtung kann dazu ausgebildet sein, in dem Messsignal einen Leistungswert zu übermitteln. In diesem Fall muss die Sensoreinrichtung also nicht nur einen Stromwert und einen Spannungswert messen, sondern diese beiden Werte auch miteinander verknüpfen, insbesondere multiplizieren. Es erfolgt also eine Vorverarbeitung der gemessenen Werte vor der Übertragung des Messsignals. Zur Übertragung anderer Werte können auch andere Verknüpfungen und Vorverarbeitungen vorgenommen werden.

Gemäß einer anderen Weiterbildung ist die Schalteinrichtung in der Schutzschaltvorrichtung zum Bereitstellen von Daten über Schaltereignisse und/oder Schaltzustände für eine Übertragung mittels der Kommunikationseinrichtung ausgebildet. Die Kommunikationseinrichtung überträgt also nicht nur ein Messsignal bezüglich Strom und/oder Spannung, sondern auch Daten über Schaltereignisse und/oder Schaltzustände der Schalteinrichtung der Schutzschaltvorrichtung. Derartige Daten über Schaltereignisse und/oder Schaltzustände können für weitere Auswertungen hilfreich bzw. nützlich sein.

Von besonderem Vorteil ist auch eine erfindungsgemäße Schutzschaltanordnung mit mehreren der oben beschriebenen Schutzschaltvorrichtungen, deren Kommunikationseinrichtungen jeweils eine Datenverbindung zu einer Schnittstelleneinrichtung aufweisen, über die sämtliche Messsignale nach außen gesendet werden. So besitzen mehrere Schutzschaltvorrichtungen eine gemeinsame Schnittstelle zur Umgebung. Die Kommunikation kann damit durch einfache Hardware realisiert werden.

Jede der Datenverbindungen zwischen den Kommunikationseinrichtungen und der Schnittstelleneinrichtung kann durch Lichtleiter realisiert sein. Gegebenenfalls können auch nur Teile dieser Datenverbindungen durch Lichtleiter verwirklicht werden. Lichtleiter gewährleisten eine Übertragung hoher Bandbreite und sind unempfindlich gegenüber elektrischen und magnetischen Einflüssen.

Die Schnittstelleneinrichtung für die Schutzschaltanordnung kann eine Signalverarbeitungseinrichtung zur Gewinnung von Diagnosedaten von den angeschlossenen Schutzschaltvorrichtungen besitzen. Durch die Signalverarbeitungseinrichtung können also Diagnosen bzw. Informationen über die Zustände der mehreren Schutzschaltvorrichtungen erstellt werden, sodass über die Schnittstelleneinrichtung nach außen alternativ zu den rohen Messsignalen der Sensoreinrichtung oder zusätzlich dazu Diagnoseinformationen an die Umgebung geschickt werden können.

Die Signalverarbeitungseinrichtung kann dazu ausgelegt sein, anhand eines Codes ein empfangenes Messsignal eindeutig einer der Schutzschaltvorrichtungen zuzuordnen. Damit ist die Signalverarbeitungseinrichtung bereits in der Lage, die Messsignale spezifisch für die Schutzschaltvorrichtungen zu trennen, sodass entsprechende Informationen intern zur Verfügung stehen oder nach außen gegeben werden können.

Die Schutzschaltanordnung mit den mehreren Schutzschaltvorrichtungen kann in einem Schaltschrank angeordnet sein. Damit steht in einem Schaltschrank eine ausführliche Diagnoseeinheit zur Verfügung, mit der es möglich ist, Stromwerte und/oder Spannungswerte in verschiedenen Strompfaden, die den jeweiligen Schutzschaltvorrichtungen zugeordnet sind, zu erfassen und für Informationszwecke nach außen bereitzustellen.

Die vorliegende Erfindung wird nun anhand der beigefügten Zeichnungen näher erläutert, in denen zeigen:
- FIG 1: ein Prinzipschaltbild der Sensorik einer Schutzschaltvorrichtung, die an ein Empfangsgerät angeschlossen ist und
- FIG 2: den prinzipiellen Aufbau einer Schutzschaltanordnung mit mehreren Schutzschaltvorrichtungen, die an eine Diagnoseeinheit angeschlossen ist.

Die nachfolgend näher geschilderten Ausführungsbeispiele stellen bevorzugte Ausführungsformen der vorliegenden Erfindung dar. Dabei ist zu beachten, dass die einzelnen Merkmale nicht nur in der geschilderten Kombination, sondern auch in Alleinstellung oder in einer anderen Kombination miteinander auftreten können.

Die vorliegende Erfindung basiert auf dem Gedanken, dass bei Schutzschaltvorrichtungen aus dem Stand der Technik zwar bekannt ist, gewisse Werte zu erfassen, die aber nicht für den Betreiber zur Verfügung zu stellen. Da Schutzschaltvorrichtungen in Stromkreise eingebaut sind, können sie auch dazu verwendet werden, Ströme zu messen und entsprechende Stromwerte bereitzustellen und/oder Spannungen zu messen und entsprechende Spannungswerte bereitzustellen. Alternativ können auch einzelne dieser Werte gemessen und in anderen Kombinationen bzw. Verknüpfungen ausgegeben werden. Ebenso können durch die Schutzschaltvorrichtungen gegebenenfalls auch andere Werte gemessen und für den Bediener bzw. Nutzer bereitgestellt werden. Entsprechende Daten können dann teilweise in der jeweiligen Vorrichtung oder in einer anderen Einheit gespeichert und für den Bediener bereitgestellt werden, damit dieser von diesen Informationen profitieren kann. So kann der Bediener bzw. Nutzer diese Informationen beispielsweise zur Einsparung von Energie, zur individuellen Schaltungsdiagnose, zum Auslösen von Alarmen und dergleichen verwenden.

Darüber hinaus wäre es wünschenswert, über die Schutzschaltvorrichtungen Echtzeitdaten zur Verfügung zu haben, die bislang nur in sehr eingeschränktem Umfang zur Verfügung stehen. Mit derartigen Daten aus Schutzschaltvorrichtungen wäre eine Echtzeitanalyse von Stromversorgungseinrichtungen möglich, sodass gegebenenfalls auch Präventivmaßnahmen ergriffen werden können.

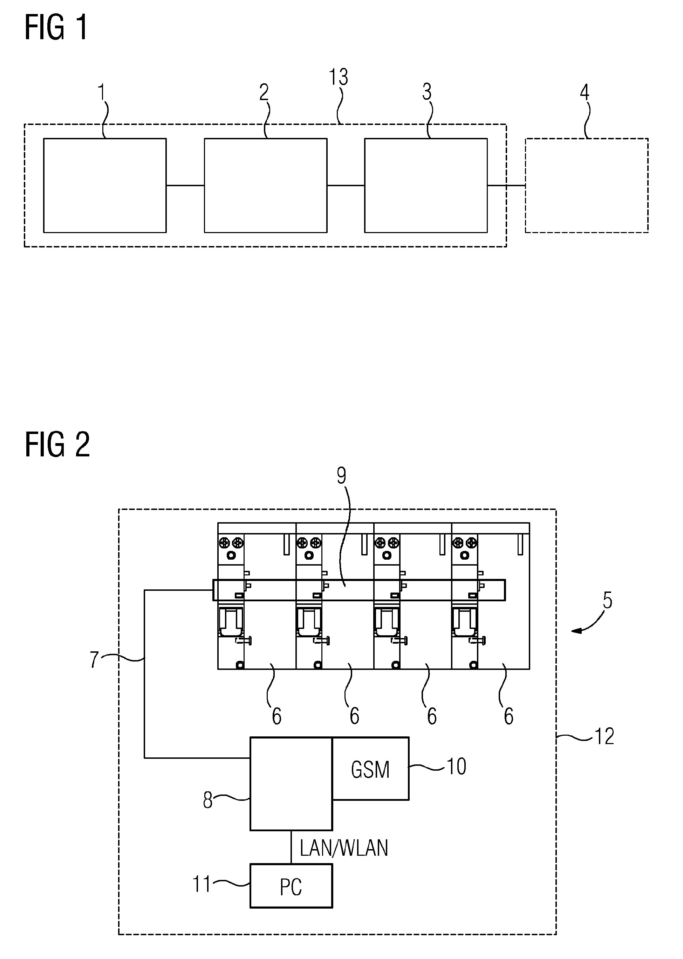

Um die genannten Vorteile zumindest teilweise zu erreichen, wird eine Schutzschaltvorrichtung mit einem Gehäuse 13 und einem Strompfad in dem Gehäuse bereitgestellt. Die Schutzschaltvorrichtung besitzt in üblicher Weise in dem Gehäuse eingebaut eine Schalteinrichtung zum Unterbrechen des Strompfads. Außerdem besitzt die Schutzschaltvorrichtung eine Sensor- und Kommunikationseinheit, wie sie symbolisch in FIG 1 dargestellt ist. Komponenten dieser Einheit sind eine Sensoreinrichtung 1, eine übliche Verarbeitungseinrichtung 2 und eine Kommunikationseinrichtung 3. Außerhalb des Gehäuses 13 der Schutzschaltvorrichtung kann eine Empfangsvorrichtung 4 vorgesehen sein, die in Kommunikationsverbindung mit der Kommunikationseinrichtung 3 steht.

Die Schutzschaltvorrichtung besitzt im vorliegenden Beispiel also eine Kommunikationseinrichtung 3, die als Kommunikationsmodul ausgebildet sein kann. Sie basiert beispielsweise auf Infrarottechnik, Bluetooth, WLAN oder anderer Drahtlostechnik. Alternativ kann die Kommunikation auch drahtgebunden beispielsweise mittels USB erfolgen.

Die Schutzschaltvorrichtung besitzt ferner die Sensoreinrichtung 1, welche einen oder mehrere Sensoren umfasst. Ein Sensor kann beispielsweise zur Messung eines Stroms und ein anderer Sensor zur Messung einer Spannung vorhanden sein. Entsprechende Strom- und/oder Spannungswerte werden in bzw. an einem Strompfad gemessen, der durch das Gehäuse der Schutzschaltvorrichtung verläuft.

Die Schutzschaltvorrichtung verfügt außerdem über die Verarbeitungseinrichtung 2, die typischerweise durch einen digitalen Schaltkreis realisiert ist. Dieser digitale Schaltkreis kann ein Mikrocontroller bzw. ein ASIC sein. Er liest die Daten von der Sensoreinrichtung 1 aus und gibt sie zur Kommunikationseinrichtung 3 weiter, welche sie an die externe Empfangsvorrichtung 4 überträgt.

Optional besitzt die Schutzschaltvorrichtung einen Code, der beispielsweise in der Kommunikationseinrichtung 3 gespeichert werden kann. Er dient dazu, dass sich die Schutzschaltvorrichtung bei einer Datenübertragung identifiziert. Dies ist beispielsweise notwendig, wenn mehrere Schutzschaltvorrichtungen 6 der genannten Art beispielsweise zu einer so genannten Schutzschaltanordnung 5 gemäß FIG 2 zusammengefügt sind. In diesem Beispiel sind vier Schutzschaltvorrichtungen 6 auf einer gemeinsamen Leiste angeordnet. Jeder dieser Schutzschaltvorrichtungen 6 dient zur Überwachung eines jeweiligen Strompfads, der in FIG 2 nicht dargestellt ist.

Sämtliche Schutzschaltvorrichtungen 6 der Schutzschaltanordnung 5 sind hier über einen gemeinsamen Kommunikationsbus 7 an eine Diagnoseeinheit 8 gekoppelt. Der Kommunikationsbus 7 kann beispielsweise einen Lichtleiter 9 aufweisen, an den sämtliche Schutzschaltvorrichtungen 6 gekoppelt sind. Dieser Lichtleiter 9 kann an die Diagnoseeinheit 8 beispielsweise mittels eines weiteren Lichtleiters oder auf andere Weise gekoppelt sein.

Jede der Schutzschaltvorrichtungen 6 besitzt eine Sensoreinrichtung 1, eine Verarbeitungseinrichtung 2 und eine Kommunikationseinrichtung 3. Die Empfangseinrichtung 4 wird im Beispiel von FIG 2 durch die Diagnoseeinheit 8 dargestellt, in der sämtliche Informationen von allen Schutzschaltvorrichtungen 6 zusammenlaufen. Die Diagnoseeinheit 8 dient dazu, die Daten zu empfangen bzw. aktiv abzuholen, zu sammeln und weiterzuschicken. Das Weiterschicken an externe Einheiten kann beispielsweise drahtlos mithilfe eines GSM-Moduls 10 erfolgen, das an die Diagnoseeinheit 8 angeschlossen ist. Alternativ oder zusätzlich kann die Diagnoseeinheit 8 aber auch eine LAN/WLAN-Schnittstelle besitzen, mit der eine Datenverbindung zu einem Rechner 11 hergestellt werden kann. All die Komponenten 5 bis 11 sind typischerweise in einem Schaltschrank 12 untergebracht.

In dem Beispiel von FIG 2 ist es nun vorteilhaft, wenn jede Schutzschaltvorrichtung ihren eigenen Code zur Identifikation besitzt. Jedes der Schutzschaltgeräte 6 kann dann durch seinen einzigartigen Identifizierungscode, der beispielsweise in einem zu übertragenden Messsignal untergebracht ist, erkannt werden. Umgekehrt kann der Code auch dazu verwendet werden, dass das jeweilige Schutzschaltgerät selektiv Daten empfängt. Solche Daten können ein Zeitwert, ein Datumswert oder auch Kommandos, wie etwa ein automatisches Abschaltkommando, oder Einstellwerte beinhalten.

Durch mindestens eine der Schutzschaltvorrichtungen 6, vorzugsweise durch alle, wird jeweils ein Stromwert und/oder Spannungswert und/oder ein auf diesen Werten basierender weiterer Wert (z. B. Leistungswert) bereitgestellt. Vorzugsweise werden zur Überwachung des Leistungsverbrauchs bzw. der Energie die Strom- und Spannungsmesswerte der Sensoren einer jeweiligen Schutzschaltvorrichtung genutzt, um eine entsprechende Schätzgröße bzw. Annäherung für einen Leistungsverbrauch des oder der Geräte, die an die Schutzschaltvorrichtung angeschlossen sind, zu ermitteln und auszugeben bzw. anzuzeigen. Eine andere Möglichkeit, diese hilfreiche Verbrauchsinformation zu nutzen, besteht darin, auf der Basis der Messwerte eine Kostenkalkulation hinsichtlich des Betriebs verschiedener Haushaltsgeräte an den Nutzer zu übermitteln. Es kann beispielsweise eine Warnmeldung abgegeben werden, wenn eine bestimmte Kostenvorgabe erreicht wird, um die intelligente Nutzung der einzelnen Geräte zu fördern. Eine diesbezügliche Information kann im Bedarfsfall an den Nutzer mit geeigneten Nachrichten übertragen werden.

Eine andere Möglichkeit der erfindungsgemäßen Überwachung und Kommunikation von Versorgungsdaten besteht im Hinblick auf das Gewinnen von spezifischen Daten von Schaltkreisen, da die jeweiligen Schaltkreise durch die Schutzschaltvorrichtungen eindeutig lokalisiert werden können. So wird beispielsweise ein Schaltkreis für eine Küche von einer anderen Schutzschaltvorrichtung versorgt als ein Schaltkreis eines Wohnzimmers oder eines Badezimmers. Es lassen sich also spezifische Daten für diese Schaltkreise gewinnen und für entsprechende Analysen nutzen.

Darüber hinaus können auch Auslösedaten in der jeweiligen Schutzschaltvorrichtung 6 gespeichert werden, um den Grund eines Fehlers zu bestimmen. Der Nutzer kann dann beispielsweise über einen direkten Alarm, eine SMS, eine E-Mail und dergleichen unmittelbar über den Fehler informiert werden. Sobald der Fehler analysiert wurde, können die jeweiligen Gründe oder zusätzliche Informationen in der Diagnoseeinheit 8 oder den Schutzschaltvorrichtungen 6 direkt für zukünftige Zwecke gespeichert werden.

Die unmittelbare Kommunikation des Fehlers an eine zuständige Behörde oder ein zuständiges Unternehmen kann auch ohne Zwischenschaltung des Nutzers erfolgen, wodurch rasche Gegenmaßnahmen ergriffen werden können. Speziell kann dann die spezifische Information bezüglich einer Schaltkreislokalisation für weitere Diagnosen und Analysen genutzt werden. Auf der Basis der gewonnenen bzw. gespeicherten Auslösedaten können ungewollte Auslösungen vermieden werden. Sobald nämlich eine ungewollte Auslösung auftritt, können die entsprechenden Wellenformen analysiert und die Schutzschaltanordnung bzw. Schutzschaltvorrichtung kann nutzerspezifisch gestaltet werden, um zukünftige ungewollte Auslösungen zu vermeiden.

Über die Kommunikationseinrichtung bzw. den damit verbundenen Kommunikationskanal kann die jeweilige Schutzschaltvorrichtung beispielsweise mit Daten bezüglich Datum, Zeit und Auslösekurven programmiert werden. So kann beispielsweise ein Überstrom, eine A-, B-, C- oder D-Auslösecharakteristik, ein 10 mA, 30 mA oder 300 mA Reststrom, eine Auslöseverzögerung oder dergleichen in die Schutzschaltvorrichtung einprogrammiert werden. Ebenso können Firmware-Updates über den Kommunikationskanal ausgeführt werden.

### Bezugszeichenliste

- 1: Sensoreinrichtung
- 2: Verarbeitungseinrichtung
- 3: Kommunikationseinrichtung
- 4: Empfangsvorrichtung
- 5: Schutzschaltanordnung
- 6: Schutzschaltvorrichtungen
- 7: Kommunikationsbus
- 8: Diagnoseeinheit
- 9: Lichtleiter
- 10: GSM-Moduls
- 11: Rechner
- 12: Schaltschrank

## Patentansprüche

1. Schutzschaltvorrichtung (6) mit
- einem Gehäuse (13),
- einem Strompfad in dem Gehäuse (13),
- einer in das Gehäuse (13) eingebauten Schalteinrichtung zum Unterbrechen des Strompfads und
- einer in das Gehäuse (13) eingebauten Kommunikationseinrichtung (3),
**gekennzeichnet durch**
- eine Sensoreinrichtung (1) zum Messen eines Stroms in dem Strompfad und/oder einer Spannung an dem Strompfad sowie zum Bereitstellen eines entsprechenden Messsignals, wobei
- die Kommunikationseinrichtung (3) zum Senden des Messsignals aus dem Gehäuse (13) ausgebildet ist.

2. Schutzschaltvorrichtung (6) nach Anspruch 1, wobei die Kommunikationseinrichtung (3) zum drahtlosen Senden des Messsignals ausgebildet ist.

3. Schutzschaltvorrichtung (6) nach Anspruch 1 oder 2, wobei in der Kommunikationseinrichtung (3) ein Code hinterlegt ist, mit dem die Schutzschaltvorrichtung (6) bei einem Senden des Messsignals oder bei einer anderen Datenkommunikation identifizierbar ist.

4. Schutzschaltvorrichtung (6) nach einem der vorhergehenden Ansprüche, wobei die Sensoreinrichtung (1) dazu ausgebildet ist, in dem Messsignal einen Leistungswert zu übermitteln.

5. Schutzschaltvorrichtung (6) nach einem der vorhergehenden Ansprüche, wobei die Schalteinrichtung zum Bereitstellen von Daten über Schaltereignisse und/oder Schaltzustände für eine Übertragung mittels der Kommunikationseinrichtung (3) ausgebildet ist.

6. Schutzschaltanordnung (5) mit mehreren Schutzschaltvorrichtungen (6) nach einem der vorhergehenden Ansprüche, deren Kommunikationseinrichtungen (3) jeweils eine Datenverbindung zu einer Schnittstelleneinrichtung (4, 8) aufweisen, für die sämtliche Messsignale gesendet werden.

7. Schutzschaltanordnung (5) nach Anspruch 6, wobei jede der Datenverbindungen durch einen Lichtleiter (7, 9) realisiert ist.

8. Schutzschaltanordnung (5) nach Anspruch 6 oder 7, wobei die Schnittstelleneinrichtung (4, 8) eine Signalverarbeitungseinrichtung zur Gewinnung von Diagnosedaten von dem angeschlossenen Schutzschaltvorrichtungen (6) besitzt.

9. Schutzschaltanordnung (5) nach Anspruch 8, wobei die Signalverarbeitungseinrichtung dazu ausgelegt ist, anhand eines Codes ein empfangenes Messsignal eindeutig einer der Schutzschaltvorrichtungen (6) zuzuordnen.

10. Schutzschaltanordnung (5) nach einem der Ansprüche 6 bis 9, die in einem Schaltschrank (12) angeordnet ist.

11. Verfahren zum Messen eines Stroms in einem Stompfad und/oder einer Spannung an einem Strompfad
**gekennzeichnet durch**
- Bereitstellen einer Schutzschaltvorrichtung (6), **durch** deren Gehäuse (13) der Strompfad hindurch verläuft,
- Messen des Stroms in dem Strompfad und/oder der Spannung an dem Strompfad innerhalb des Gehäuses (13) und Bereitstellen eines entsprechenden Messsignals, und
- Senden des Messsignals aus dem Gehäuse (13) heraus.
